# EUROPEAN PATENT APPLICATION

(11) **EP 2 873 984 A1**
(43) Date of publication of application: **20.05.2015**
(21) Application number: 13816692.1
(22) Date of filing: 28.06.2013
(51) Int. Cl.: G01R 31/36, H01M 10/48

(54) **SENSOR TAG AND SENSOR NETWORK SYSTEM**

(30) Priority: 13.07.2012 JP 2012157915
(71) Applicant: Murata Manufacturing Co., Ltd., Nagaokakyo-shi, Kyoto 617-8555 (JP)
(72) Inventor: HARUTA, Kazumasa, Nagaokakyo-shi, Kyoto 617-8555 (JP)
(74) Representative: Reeve, Nicholas Edward
(86) International application number: PCT/JP2013/067802
(87) International publication number: WO 2014/010436

(57) **Abstract**

A sensor tag (2) includes a sensor (28A), a resistor (28B), an RFIC (22), a battery (29) and an MCU (25). The sensor (28A) detects an environmental state. The battery (29) is connected to a series circuit, which includes the sensor (28A) and the resistor (28B), and to the RFIC (22) and the MCU (35). The MCU (35) detects a voltage across the two ends of the resistor (28B), detects a current flowing from the battery (29) to the sensor (28A), transmits information relating to the current to a tag reader (3) and causes information relating to a remaining battery amount of the battery (29) to be displayed on the tag reader (3).

## Description

### Technical Field

The present invention relates to a sensor tag that wirelessly transmits a detection result of a sensor and to a sensor network system in which a sensor tag and a tag reader are connected to each other via a network.

### Background Art

In the related art, the direct-current voltage and direct-current current applied to an electronic component may be measured, and deterioration and malfunctioning of the electronic component may be detected on the basis of the results of these measurements (for example, refer to Patent Documents 1 to 3).

In the example of the related art described in Patent Document 1, a known resistance is connected in series with a target test device, the voltage across the two ends of this resistance is measured and the current that is flowing through the target test device is measured. Then, whether the target test device is normal or defective is determined on the basis of the measured current.

In the example of the related art described in Patent Document 2, the resistance of a solder junction is measured in order to determine whether the solder junction is normal or defective.

In the example of the related art described in Patent Document 3, there are disclosed a device that determines whether a solar cell element included in a solar cell module is defective and a device that communicates via a network information instructing replacement of a solar cell element determined to be defective by that device.

### Citation List

### Patent Documents

Patent Document 1: International Publication No. 2008/059766
Patent Document 2: Japanese Unexamined Patent Application Publication No. 2009-264959
Patent Document 3: International Publication No. 2007/129585

### Summary of Invention

### Technical Problem

With the progress in radio frequency identification (RF-ID) technology and detection technology in recent years, various sensors network systems have appeared in which a sensor tag and a tag reader are used in combination with each other.

Such a sensor tag may be formed so as to include a sensor module, a wireless communication module and a battery. Examples of sensor modules that are utilized include one in which the load varies as a result of detection such as a sensor employing a temperature-sensitive resistance element or a magneto-resistive element, and one that outputs a detection signal such as a gas sensor.

In such a sensor network system, even if none of the electronic components described above are defective, the sensor may become unable to perform detection due to the battery being exhausted. In particular, the battery lifetime of a sensor tag is substantially shortened when the load (resistance) of the sensor module is very small compared with the load (resistance) of the wireless communication module as a result of the large current flowing through the sensor module. A battery having a large capacity and a long life is commonly used, but this leads to the cost of the battery being increased.

Accordingly, an object of the present invention is to realize a sensor tag that can be used in a sensor network once the user of the sensor network has accurately grasped the remaining battery amount and battery life of the sensor tag and to realize the sensor network system. Thus, it is possible to prevent, without using a battery having a large capacity and a long lifetime, the situation in which the sensor becomes unable to perform detection while the sensor tag is being used due to the battery expiring. Solution to Problem

A sensor tag of the present invention includes a sensor, a communication unit, a battery, a detection unit and a control unit. The sensor detects an environmental state. The communication unit transmits environment information based on a result detected by the sensor. The battery is connected to at least the sensor and the communication unit. The detection unit detects circuit information relating to a current that flows from the battery to the sensor. The control unit causes the environment information to be transmitted by the communication unit.

A sensor network system of the present invention includes a sensor tag and a tag reader. The sensor tag includes a sensor, a communication unit, a battery, a detection unit and a control unit. The sensor detects an environmental state. The communication unit transmits environment information based on a result detected by the sensor. The battery is connected to at least the sensor and the communication unit. The detection unit detects circuit information relating to a current that flows from the battery to the sensor. The control unit causes the environment information and the circuit information to be transmitted by the communication unit. The tag reader includes a communication unit, a control unit and a reporting unit. The communication unit receives the environment information and the circuit information from the sensor tag. The control unit performs processing based on the environment information received by the communication unit and obtains information relating to a remaining amount of the battery on the basis of the circuit information received by the communication unit. The reporting unit reports the information relating to the remaining amount of the battery obtained by the control unit.

In the above-described sensor tag and sensor network system, it is preferable that the detection unit of the sensor tag include a resistor that is connected in series with the sensor.

In addition, it is preferable that the above-described sensor tag and sensor network system include voltage detection means, current detection means, total current consumption estimation means and remaining battery amount estimation means. The voltage detection means detects a voltage applied from the battery to the resistor. The current detection means detects a current that flows from the battery to the sensor on the basis of the voltage detected by the voltage detection means and a known resistance of the resistor. The total current consumption estimation means estimates a total current consumption of the sensor tag on the basis of the current detected by the current detection means and a known current consumption of the communication unit. The remaining battery amount estimation means estimates a remaining amount of the battery on the basis of the total current consumption estimated by the total current consumption estimation means and a known battery capacity of the battery.

### Advantageous Effects of Invention

According to the present invention, a sensor tag or tag reader reports information relating to a remaining battery amount of the sensor tag and consequently, for example, the user of a sensor network system is able to check and grasp the remaining battery amount of the sensor tag. Thus, the user is able to take measures regarding the sensor tag that are in accordance with the remaining amount of the battery, and a situation in which the sensor becomes unable to perform detection due to the battery expiring while the sensor tag is in use can be prevented without using a battery that has a large capacity and a long life.

### Brief Description of Drawings

[Fig. 1] Fig. 1 is a block diagram of a sensor network system according to a first embodiment of the present invention.
[Fig. 2] Fig. 2 is a block diagram of a sensor network system according to a second embodiment of the present invention.

### Description of Embodiments

### «First Embodiment»

Hereafter, a first embodiment of a sensor tag and a sensor network system according to the present invention will be described. The sensor network system according to the first embodiment includes a sensor tag 2 and a tag reader 3.

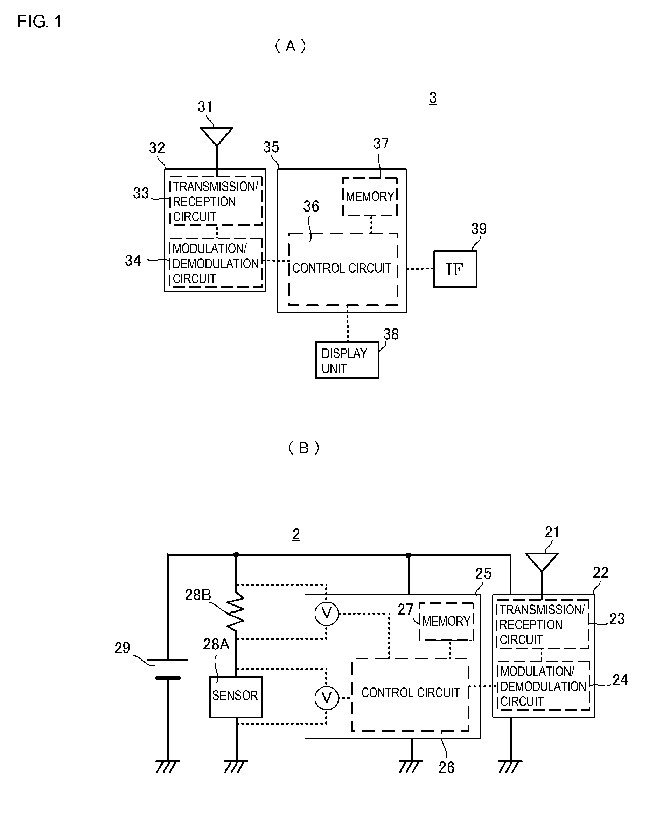

Fig. 1(A) is a block diagram of the tag reader 3 of the sensor network system according to the first embodiment. In addition, Fig. 1(B) is a block diagram of the sensor tag 2 of the sensor network system according to the first embodiment.

In the sensor network system of this embodiment, the sensor tag 2 and the tag reader 3 communicate with each other using a known RFID technique. The sensor tag 2 wirelessly transmits a detection result (hereafter, environment information) of a sensor 28A, which will be described later, and a detection result (hereafter, circuit information) of a current flowing from a battery 29, which will be described later, to the sensor 28A to the tag reader 3. The tag reader 3 receives the detection results transmitted from the sensor tag 2, obtains information relating to a remaining amount of the battery 29 based on the detection result of the current flowing to the sensor 28A, and reports this information to for example the user of the sensor network system.

Hereafter, the tag reader 3 and the sensor tag 2 will be described in detail.

The tag reader 3 illustrated in Fig. 1(A) includes an antenna 31, a radio frequency integrated circuit (RFIC) 32, a micro-control unit (MCU) 35, a display unit 38 and an interface unit (IF) 39.

The RFIC 32 includes a transmission/reception circuit 33 and a modulation/demodulation circuit 34. The transmission/reception circuit 33 performs wireless communication with the sensor tag 2 via the antenna 31. The modulation/demodulation circuit 34 modulates a transmission signal and demodulates a reception signal. The RFIC 32 and the antenna 31 form a communication unit of the tag reader 3 in the present embodiment.

The MCU 35 includes a control circuit 36 and a memory 37. The control circuit 36 outputs various commands to the modulation/demodulation circuit 34 using a serial signal. In this way, the modulation/demodulation circuit 34 modulates such a command in a transmission signal and transmits the modulated command to the sensor tag 2. In addition, the control circuit 36 reads out environment information and circuit information obtained by the sensor tag 2 from a demodulated signal input from the modulation/demodulation circuit 34. Then, the control circuit 36 performs processing in accordance with the contents of the environment information and the circuit information and obtains information relating to the remaining amounts of the battery 29 (remaining battery amount and battery lifetime) based on at least the circuit information. The memory 37 stores the environment information and the circuit information read out by the control circuit 36. The display unit 38 displays (reports) information relating to the remaining amounts of the battery 29 obtained by the control circuit 36. The IF 39 performs communication with an external circuit via a cable and inputs and outputs the environmental information and the circuit information stored in the memory 37, command signals from the external circuit and so forth to and from the external circuit. In addition, the MCU 35 corresponds to a control unit of the tag reader 3 in this embodiment. Furthermore, the display unit 38 corresponds to a reporting unit in this embodiment.

The sensor tag 2 illustrated in Fig. 1(B) includes an antenna 21, an RFIC 22, an MCU 25, the sensor 28A, a resistor 28B and the battery 29.

The sensor 28A is for example a temperature sensor or a humidity sensor and detects an environmental state by utilizing the fact that its resistance changes with an environmental state value such as the temperature or the humidity of the surroundings. The resistor 28B has a resistance on the order of for example 100 kΩ and is connected in series with the sensor 28A along the power supply line extending between the battery 29 and the ground. In addition, the resistor 28B corresponds to a detection unit in this embodiment.

The RFIC 22 and the MCU 25 are connected in parallel with the sensor 28A and the resistor 28B along the power supply line extending between the battery 29 and the ground.

The RFIC 22 includes a transmission/reception circuit 23 and a modulation/demodulation circuit 24. The transmission/reception circuit 23 performs wireless communication with the tag reader 3 via the antenna 21. The modulation/demodulation circuit 24 modulates a transmission signal and demodulates a reception signal. The RFIC 22 and the antenna 21 form a communication unit of the sensor tag 2 in the present embodiment.

The MCU 25 includes a control circuit 26 and a memory 27. The control circuit 26 identifies a command from a demodulated signal input from the modulation/demodulation circuit 24 and performs processing in accordance with the command. For example, the control circuit 26 obtains circuit information when the command is a response request command for circuit information. The control circuit 26 obtains environment information when the command is a response request command for environment information. In addition, the control circuit 26 obtains the circuit information and the environment information at a certain operation timing. Furthermore, the MCU 25 corresponds to a control unit of the sensor tag 2 in the present embodiment.

When the environment information is to be obtained, the control circuit 26 first detects the voltage across the two ends of the sensor 28A and the voltage across the two ends of the resistor 28B. The ratio between these voltages is equal to the ratio between the resistance of the sensor 28A and the resistance of the resistor 28B. Next, the control circuit 26 calculates the resistance of the sensor 28A from the resistance of the resistor 28B and the above-mentioned voltage ratio. The resistance of the sensor 28A changes in accordance with an environmental state value. Then, the control circuit 26 estimates a corresponding environmental state value from the resistance of the sensor 28A. After that, the control circuit 26 causes the obtained environmental state value to be transmitted to the tag reader 3 as environment information.

In order to realize these processing operations using the control circuit 26, a table or a formula expressing a correspondence relation between the voltage ratio between the voltage across the two ends of the sensor 28A and the voltage across the two ends of the resistor 28B, and an environmental state value may be stored in advance in the memory 27. Then, the control circuit 26 may detect the voltage across the two ends of the sensor 28A and the voltage across the two ends of the resistor 28B and obtain an environmental state value that corresponds to the ratio of these two voltages by using the table or the formula stored in the memory 27.

In addition, although an example has been illustrated here in which an environmental state value is transmitted to the tag reader 3 as environment information, for example, the voltage across the two ends of the sensor 28A, the voltage across the two ends of the resistor 28B, the ratio between these voltages and the resistance of the sensor 28A may be transmitted as environment information. In this case, the tag reader 3 may obtain the environmental state value from the received environment information.

In addition, when the circuit information is to be obtained, the control circuit 26 performs voltage detection processing, current detection processing, total current consumption estimation processing and remaining battery amount estimation processing. The voltage detection processing is processing in which the voltage applied from the battery 29 to the resistor 28B is detected. In addition, the current detection processing is processing in which the current flowing from the battery 29 to the sensor 28A is detected on the basis of the voltage detected in the voltage detection processing and the known resistance of the resistor 28B. The total current consumption estimation processing is processing in which the total current consumption of the sensor tag 2 is estimated on the basis of the current detected in the current detection processing, the known current consumption of the RFIC 22 and the known current consumption of the MCU 25. The remaining battery amount estimation processing is processing in which the remaining battery amount and the battery lifetime are estimated on the basis of the total current consumption estimated in the total current consumption estimation processing and the known battery capacity of the battery 29. That is, the control circuit 26 has the functions of voltage detection means, current detection means, total current consumption estimation means and remaining battery amount estimation means.

After obtaining the estimated values of the remaining battery amount and battery lifetime through these processing operations, the control circuit 26 causes the obtained estimated values of the remaining battery amount and the battery lifetime to be transmitted to the tag reader 3 as circuit information.

In order to realize these processing operations using the control circuit 26, a table or formula expressing a correspondence relationship between the voltage across the two ends of the resistor 28B and estimated values of the remaining battery amount and the battery lifetime may be stored in advance in the memory 27. Then, the control circuit 26 may detect the voltage across the two ends of the resistor 28B and obtain estimated values of the remaining battery amount and the battery lifetime that correspond to this voltage by using the table or formula stored in the memory 27.

In addition, although an example has been illustrated here in which estimated values of the remaining battery amount and the battery lifetime are transmitted to the tag reader 3 as circuit information, the voltage, the current and the total current consumption of the sensor tag 2 may be transmitted as circuit information. In the case where such values are transmitted as circuit information, in the tag reader 3, current detection processing, total current consumption estimation processing and remaining battery amount estimation processing may be performed and estimated values of the remaining battery amount and the battery lifetime may be obtained from the received circuit information.

Thus, circuit information and environment information are obtained and transmitted to the tag reader 3 by the sensor tag 2. Then, in the tag reader 3, information relating to the environmental state value and information relating to the remaining battery amount detected by the sensor tag 2 are obtained from the circuit information and the environment information and at least the information relating to the remaining battery amount is displayed on the display unit 38.

Thus, for example, the user of the sensor network system will be able to grasp the remaining battery amount of the sensor tag 2 by checking the display on the tag reader 3. Then, the user will be able to take measures regarding the sensor tag 2 that are in accordance with the remaining battery amount and a situation in which the sensor 28A becomes unable to perform detection due to the battery 29 expiring while the sensor tag 2 is in use can be prevented without using a battery that has a large capacity and a long life.

In addition, in the configuration of this embodiment, the resistor 28B is connected in series with the sensor 28A, and therefore the combined resistance of the series circuit composed of the sensor 28A and the resistor 28B is larger than the simple resistance of the sensor 28A. Consequently, an effect is obtained in that the current that flows through this series circuit is small and the life of the battery 29 can be extended.

The resistance of the resistor 28B is preferably set to an appropriate value. If the resistance of the resistor 28B is too large, the voltage applied to the sensor 28A is reduced and there is a possibility that the sensor 28A will no longer operate. Conversely, if the resistance of the resistor 28B is too small, the current flowing through the resistor 28B and the sensor 28A is increased and consequently the effect that the life of the battery 29 is extended due to the resistor 28B being connected in series with the sensor 28A is reduced.

In addition, in the case where the sensor tag 2 is employed in an application in which resistance of the sensor 28A is small throughout almost the entirety of its operation period, obtaining of circuit information and transmission of the circuit information to the tag reader 3 may be performed only at the start of the operation period of the sensor tag 2. Also in this case, it is possible for the user to grasp that the sensor network system will stop in a shorter time than might be assumed and the user can be urged to take appropriate action.

In addition, in the case where the sensor tag 2 is used in an application in which the resistance of the sensor 28A continually varies during its operation period, obtaining of the circuit information may be repeatedly performed during the operation period of the sensor tag 2. In this case, transmission of the circuit information to the tag reader 3 is performed as the circuit information relating to the remaining battery amount of the battery 29 is updated and as a result the user is able to grasp a more accurate remaining battery amount of the battery 29 and the user can be urged to take appropriate action when the remaining amount of the battery 29 becomes particularly small.

Obtaining of the circuit information and transmission of the circuit information to the tag reader 3 may be performed in the sensor tag 2 in response to transmission of a request signal from the tag reader 3 to the sensor tag 2, or the sensor tag 2 may perform these operations autonomously. For example, the tag reader 3 may perform polling at a certain timing and the sensor tag 2 may transmit the circuit information to the tag reader 3 upon receiving the polling. In addition, the sensor tag 2 may autonomously transmit the circuit information to the tag reader 3 intermittently every certain time interval.

In addition, reporting of the life of the battery 29 in the tag reader 3 is not limited to being realized by display on the display unit 38 and for example may instead be realized by emission of sound by a sound emission unit. In addition, reporting of the life of the battery 29 may be performed by the sensor tag 2 rather than by the tag reader 3 or reporting of the life of the battery 29 may be performed by both the tag reader 3 and the sensor tag 2.

### «Second Embodiment»

Hereafter, a second embodiment of a sensor tag and a sensor network system according to the present invention will be described. The sensor network system according to the second embodiment includes a sensor tag 52 and a tag reader 53.

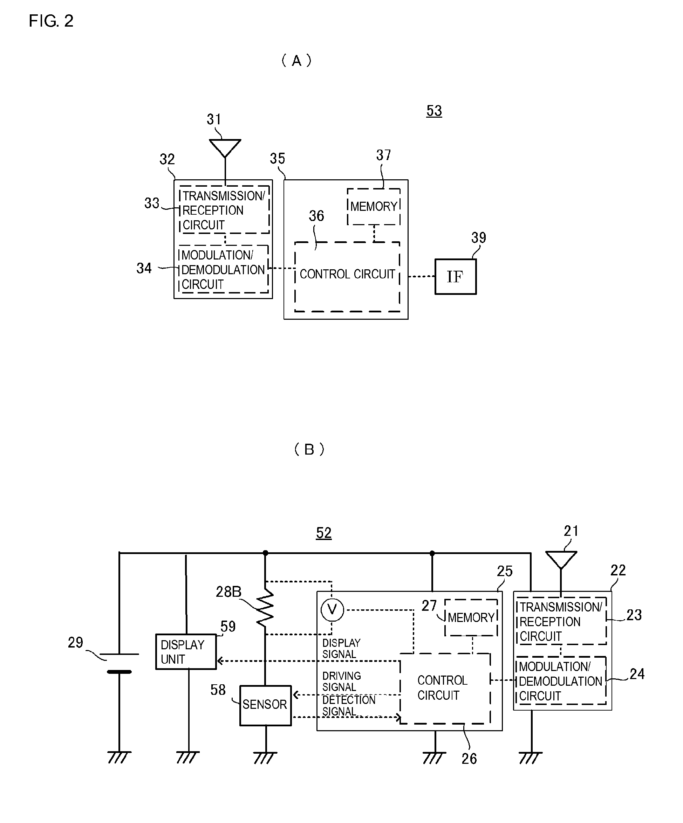

Fig. 2(A) is a block diagram of the tag reader 53 of the sensor network system according to the second embodiment. In addition, Fig. 2(B) is a block diagram of the sensor tag 52 of the sensor network system according to the second embodiment. Here, like symbols are used to denote like components described in the first embodiment.

In the sensor network system of the present embodiment, the sensor tag 52 is configured such that environment information is transmitted to the tag reader 53 but circuit information is not transmitted. The tag reader 53 illustrated in Fig. 2(A) has a configuration obtained by omitting the display unit from the configuration of the tag reader 3 of the first embodiment.

In addition, in this sensor network system, a sensor 58 of the sensor tag 52 illustrated in Fig. 2(B) is configured to utilize changing of a detection signal with the environmental state rather than changing of its resistance with an environmental state value such as the temperature or humidity of the surroundings. In addition, compared with the configuration of the sensor tag 2 of the first embodiment, the sensor tag 52 has a configuration that additionally includes a display unit 59.

The sensor tag 52 illustrated in Fig. 2(B) includes the antenna 21, the RFIC 22, the MCU 25, the sensor 58, the resistor 28B, the display unit 59 and the battery 29.

The sensor 58 is for example a gas sensor, an angular velocity sensor or an acceleration sensor, and detects the environmental state by being input with a frequency signal serving as a driving signal, and outputting as a detection signal a frequency signal obtained by frequency modulating the driving signal in accordance with the concentration of a specific gas or the magnitude of the applied angular velocity or acceleration.

When the environment information is to be obtained, the control circuit 26 first reads out the amount of frequency modulation in the detection signal of the sensor 58. The frequency of the detection signal of the sensor 58 is modulated in accordance with an environmental state value such as the concentration of a specific gas or the magnitude of the applied angular velocity or acceleration. Next, the control circuit 26 estimates a corresponding environmental state value from the detection signal of the sensor 58. After that, the control circuit 26 causes as a serial signal the obtained environmental state value to be transmitted to the tag reader 3 as environment information.

In order to realize these processing operations using the control circuit 26, a table or formula expressing a correspondence relationship between the amount of frequency modulation and the environmental state value may be stored in advance in the memory 27. The control circuit 26 may detect the amount of frequency modulation and obtain an environmental state value corresponding to that amount of frequency modulation by using the table or formula stored in the memory 27.

In addition, here, although an example has been illustrated in which an environmental state value is transmitted to the tag reader 3 as environment information, the amount of frequency modulation may instead be transmitted as environment information. In this case, the tag reader 3 may obtain the environmental state value from received environment information.

In addition, when circuit information is to be obtained, the control circuit 26 performs voltage detection processing, current detection processing, total current consumption estimation processing and remaining battery amount estimation processing, similarly to as in the first embodiment. Thus, the control circuit 26 obtains estimated values of the remaining battery amount and the battery lifetime. After obtaining the estimated values of the remaining battery amount and the battery lifetime through these processing operations, the control circuit 26 causes the estimated values to be displayed on the display unit 59.

Therefore, for example, the user of the sensor network system is able to grasp the remaining amount of the battery 29 by checking the display of the display unit 59. Thus, the user will be able to take measures regarding the sensor tag 52 that are in accordance with the remaining battery amount, and a situation in which the sensor 28A becomes unable to perform detection due to the battery 29 expiring while the sensor tag 2 is in use can be prevented without using a battery that has a large capacity and a long life. Reference Signs List

2, 52...sensor tag
3, 53...tag reader
21, 31...antenna
22, 32...RFIC
23, 33 transmission/reception circuit
24, 34...modulation/demodulation circuit
25, 35...MCU
26, 36...control circuit
27, 37...memory
28A, 58...sensor
28B...resistor
29...battery
38, 59...display unit

## Claims

1. A sensor tag comprising:
a sensor that detects an environmental state;
a communication unit that transmits environment information based on a result detected by the sensor;
a battery that is connected to at least the sensor and the communication unit;
a detection unit that detects circuit information relating to a current that flows from the battery to the sensor; and
a control unit that causes the environment information to be transmitted by the communication unit.

2. The sensor tag according to Claim 1, wherein the detection unit includes a resistor that is connected in series with the sensor.

3. The sensor tag according to Claim 2, further comprising:
voltage detection means for detecting a voltage that is applied from the battery to the resistor;
current detection means for detecting a current that flows from the battery to the sensor on the basis of the voltage detected by the voltage detection means and a known resistance of the resistor;
total current consumption estimation means for estimating a total current consumption of the sensor tag on the basis of the current detected by the current detection means and a known current consumption of the communication unit; and
remaining battery amount estimation means for estimating a remaining amount of the battery on the basis of the total current consumption estimated by the total current consumption estimation means and a known battery capacity of the battery.

4. A sensor network system comprising:
the sensor tag according to any one of Claims 1 to 3; and
a tag reader including a communication unit that receives the environment information from the sensor tag and a control unit that performs processing based on the environment information received by the communication unit.

5. A sensor network system comprising:
a sensor tag including
a sensor that detects an environmental state,
a communication unit that transmits environment information based on a result detected by the sensor,
a battery that is connected to at least the sensor and the communication unit,
a detection unit that detects circuit information relating to a current that flows from the battery to the sensor, and
a control unit that causes the environment information and the circuit information to be transmitted by the communication unit; and
a tag reader that including
a communication unit that receives the environment information and the circuit information from the sensor tag,
a control unit that performs processing based on the environment information received by the communication unit and obtains information relating to a remaining amount of the battery on the basis of the circuit information received by the communication unit, and
a reporting unit that reports the information relating to the remaining amount of the battery obtained by the control unit.

6. The sensor network system according to Claim 5, wherein the detection unit of the sensor tag includes a resistor that is connected in series with the sensor.

7. The sensor network system according to Claim 6, further comprising:
voltage detection means for detecting a voltage that is applied from the battery to the resistor;
current detection means for detecting a current that flows from the battery to the sensor on the basis of the voltage detected by the voltage detection means and a known resistance of the resistor;
total current consumption estimation means for estimating a total current consumption of the sensor tag on the basis of the current detected by the current detection means and a known current consumption of the communication unit; and
remaining battery amount estimation means for estimating a remaining amount of the battery on the basis of the total current consumption estimated by the total current consumption estimation means and a known battery capacity of the battery.
